# EUROPEAN PATENT SPECIFICATION

(11) **EP 4 038 298 B1**
(45) Date of publication and mention of the grant of the patent: **03.12.2025**
(21) Application number: 19943142.0
(22) Date of filing: 23.08.2019
(51) Int. Cl.: F16L 5/08, F16L 5/14, H02G 3/22, H05K 9/00, H02G 3/06

(54) **CABLE FEEDTHROUGH ELEMENT**
KABELDURCHFÜHRUNGSELEMENT
ÉLÉMENT PASSE-CÂBLE

(43) Date of publication of application: 10.08.2022
(73) Proprietor: Bimed Teknik Aletler Sanayi ve Ticaret Anonim Sirketi, Beylikdüzü/Istanbul (TR)
(72) Inventor: AKBUKREK, Yilmaz, stanbul (TR); AYGÜN, Muhammet, Istanbul (TR)
(74) Representative: Mutlu, Aydin
(86) International application number: PCT/TR2019/050697
(87) International publication number: WO 2021/040632

(56) References cited:
- EP-A1- 3 107 155
- DE-C1- 19 824 808
- JP-A- 2009 153 280
- JP-U- H0 736 545
- US-A- 5 362 251
- US-A1- 2013 084 741
- US-A1- 2019 260 166
- US-B1- 6 639 146

## Description

### Technical Field

The invention relates to a cable feedthrough element for feeding cables through an opening in a mounting panel.

More particularly, the invention relates to a cable feedthrough element which ensures electromagnetic compatibility for feeding shielded cables through the opening in the mounting panel.

### Background of The Invention

All electrical and electronic devices emit some electromagnetic energy to the environment during operation. This electromagnetic field has a direct effect on devices and cables. Electromagnetic Interference is the effect of devices or systems from this energy that is produced or present in the environment. The electromagnetic field has a particularly negative effect on the operation of highly sensitive electronic devices and impair the operating accuracy of these devices and the accuracy of the signals.

Electromagnetic Compatibility can be defined as the fact that one device or system does not affect other devices or systems while they are operating and is not affected by their operation.

One of the main factors determining the quality of electromagnetic compatibility is the cables connecting the devices. Because the cables act as both electrical and magnetic interference sources.

For the above-mentioned reasons, shielded cables are used in areas where environmental interference is important. These types of cables are used with EMC type cable glands. EMC type cable glands ensure grounding shielded (screened) cables.

In present art, the contact elements tighten shielded cables by means of sealing element and EMC feature is provided. The sealing element is compressed by one of the parts forming the cable feedthrough element. In this compression operation, the sealing element abuts against and pushes the contact element. The contact element presses the cable shield with the force transmitted by the sealing element.

However, the biggest disadvantage of this working principle is that the sealing elements produced from the elastomer material lose their elasticity due to the effects of aging. Less force is transmitted from the sealing element (which loses its elasticity) to the contact element over time. This causes the contact element to press the cable shield with a decreasing force. As a result, the EMC feature may be interrupted and the system may be damaged. The cable feeding element does not meet the expected screening and grounding characteristics.

EP1886390 discloses a frame that provides cable passage and reduces electromagnetic interference. The frame comprises compressible modules through which the cables can pass, the conductive layer in contact with said modules and the clamping unit. The installation of said frame is a complex and time-consuming process due to the parts that it contains. In addition, installation errors can occur depending on the dexterity and experience of the operator. Installation errors are unacceptable as they will reduce EMC performance. Due to the aging effect, the modules through which the cables pass, press the cable less in time. In this case, the EMC feature may be interrupted. Therefore, it may be necessary to tighten the clamping unit at certain intervals.

JPH0736545U discloses a cable gland for use with an armored cable. The cable gland comprises a grounding member made of conductive metal and a waterproof ring made of rubber. The grounding member is connected to the waterproof ring. The grounding member has a plurality of grounding pieces. The tip portion of each grounding piece is bent in a hook shape inward. The tip portion of each grounding piece bites into the steel pipe outer surface of the armored cable when the cable gland is assembled. Therefore, the body of the cable gland and the steel pipe is electrically connected by means of the ground member. The steel pipe is also prevented to come off from the ground member. Thus, the connection strength of the armored cable is increased.

JP2009153280A discloses a terminal processing structure related to the fastening of the shielding wire of the harness wired. It comprises a metal annular shell, a metal annular bracket and a shielding case. The annular shell has notches and the mesh of the shielding wire is hooked on them. The front end of the mesh is folded and the shielding wire is connected to the annular shell. The annular shell is mounted in the annular bracket by means of locking parts. The annular bracket is screwed into the shielding case. Thus, the annular shell and the shielding case are directly contacted, and also the shielding wire conductively contacts directly the shielding case.

US6639146B1 discloses a cable connector for fastening a cable to a metal box and which eliminates electromagnetic interference. The cable connector generally comprises a metal casing, a packing barrel, a plastic clamping ring, a metal packing nut, and a metal conducting plate. The metal casing is fastened to a metal box by a gasket ring and a lock nut to hold a cable. The flexible packing barrel and the plastic clamping ring are mounted on one end of the metal casing. The packing nut is fastened to one end of the metal casing to compress the plastic clamping ring and the flexible packing barrel against the outer insulator of the cable. The metal conducting plate is placed between a step inside the metal casing and one end of the flexible packing barrel and is adapted for transmitting electromagnetic waves from the cable to the metal casing and then the metal box.

DE19824808C1 discloses a mounting arrangement for elongated structures such as cables, hoses, or the like, which have an electrical shielding sheath. The mounting arrangement has an electrically conducting insert with a retaining ring and clamping fingers. The clamping fingers provide an electrically conductive connection between the electrically conductive connection and the electrical shielding sheath in the usage position. The clamping fingers have projections that apply force to the clamping fingers to bend radially inwardly when the insert is located into a receptacle opening. Therefore, the clamping fingers press onto the electrical shielding of the cable and provide good contact with it.

As a result, due to above described disadvantages and inadequacy of existing solutions, it has been necessary to make development in the related art.

### Purpose of The Invention

The invention has been developed with inspiration from existing situation and purposes to eliminate the above-mentioned disadvantages.

The main purpose of the invention is to prevent electromagnetic fields from passing through the cable feedthrough element in any direction and to direct unwanted electromagnetic energy carried by the cable shield to the ground. Thus, 360 ° electromagnetic compatibility (EMC) is provided in the system where the cable feedthrough element is used.

Another purpose of the invention is to provide an EMC property independent from aging. For this purpose, there is a protrusion which ensures contact continuity of the contact element.

Another purpose of the invention is to allow the simultaneous assembly of a plurality of cables together. This saves both installation space and time. The cable feedthrough ensures that large diameter high-current cables are installed close to each other in the mounting panel, thus saving installation space and time.

Another purpose of the invention is to prevent loss and damage of the contact element during the assembly of pre-terminated cables such as cable lugs and connectors. The contact element is positioned in a groove in the cable feedthrough element. This prevents loss and damage of the contact element. In addition, the installation time is reduced.

Another purpose of the invention is to simplify installation by reducing the need for complex components. This reduces installation failures.

It is a further purpose of the invention to provide the inspectability the contacting of the contact element to the cable shield during assembling. Thus, it is visually proved that the EMC feature is fully achieved. This increases user satisfaction and confidence. It also accelerates fault detection and intervention in the event of a failure.

A cable feedthrough element for installing shielded cables is invented to achieve the above-mentioned purposes, comprising; a lower body mounted in the opening on a mounting panel and having at least one housing providing passage of the shielded cable, at least one sealing element disposed in said at least one housing and providing sealing protection, an upper body mounted on the lower body, at least one tubular part protruding on the upper body and providing passage of shielded cable, at least one contact element for contacting the shielded cable and having at least one contact spring contacting on at least one point of the shielded cable when the shielded cable is pressed, at least one bend on the contact spring which retains the contact element in the tubular part by engaging a groove formed in the tubular part, at least one retaining ring which has at least one contact spring on it and which allows the bend to dislocate from the groove by the sealing element pushing the contact element during the assembly of the upper body to the lower body and at least one protrusion which is adjacent to the groove and allowing the contact element to continuously press the shielded cable by preventing the bend to return back to the groove.

The structural and characteristic features and all advantages of the invention will be clarified with the detailed description of the figures and the following description. Therefore, the evaluation should be done by taking into account these figures and detailed explanation.

### Brief Description of Figures

**Figure 1****:** is an exploded view of the cable feedthrough element.
**Figure 2****:** is an assembled view of the cable feedthrough element.
**Figure 3****:** is a cross-sectional view of the cable feedthrough element with cable assembly.
**Figure 4****:** is a cross-sectional view of the upper body without contact element.
**Figure 5****:** is an overview of a preferred embodiment of the contact element.

### Description of Part References

A. Shielded cable
B. Cable feedthrough element
10. Lower body
11. Housing
20. Upper body
21. Shelter part
22. Tubular part
23. Groove
24. Protrusion
25. Recess
30. Sealing element
31. Slit
40. Contact element
41. Contact spring
42. Bend
43. Retaining ring
44. Extension
50. Shroud
51. Tab
52. Annular extension
60. Connecting element
70. Mounting panel

### Detailed Description of the Invention

In this detailed description, the preferred embodiments of a cable feedthrough element (B) disclosed under the invention have been disclosed solely for the purpose of better understanding of the subject.

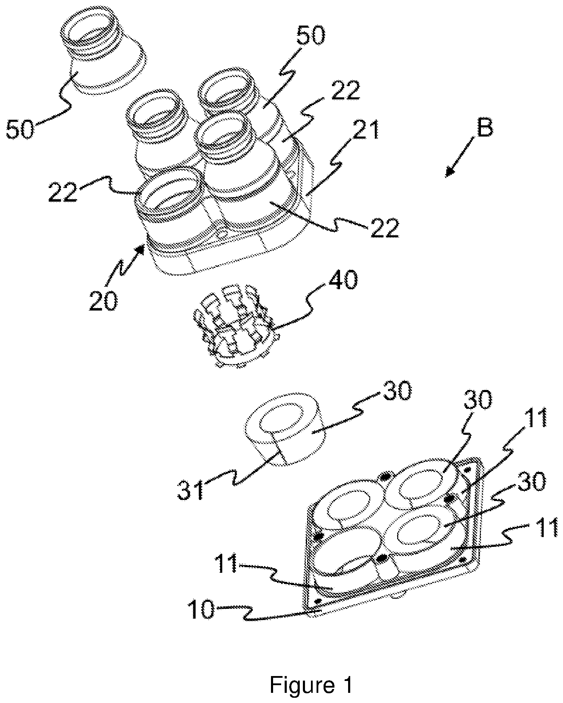

Referring to Fig. 1, the cable feedthrough element (B) according to the invention comprises the lower body (10), the upper body (20), the sealing element (30) and the contact element (40). The cable feedthrough element (B) allows the plurality of shielded cables (A) to pass through the opening formed on a mounting panel (70). The cable feedthrough element (B) provides electromagnetic compatibility (EMC) by grounding of shielded cables (A). Thus, electrical and electronic devices and systems are not affected by electromagnetic interference. The cable feedthrough element (B) allows passage of more than one shielded cable (A), thus saves installation space. The cable diameter increases depending on the amount of energy transferred by the cable. In particular, cables used in energy systems such as wind turbines, solar panels etc. have larger diameters than the one used in other industrial applications. In addition, these energy systems have both cable clutter and limited installation space. The cable feedthrough element (B) has advantage particularly in such places. The cable feedthrough element (B) also enables the simultaneous assembly of multiple cables, thus reducing the installation time.

The lower body (10) enables the cable feedthrough element (B) to be mounted in the opening on the mounting panel (70). The lower body (10) may be mounted in the opening on the mounting panel (70) from the front or rear. Thus, the user can mount the lower body (10) in a preferred direction within the confined installation space and in the cable clutter. The lower body (10) is preferably made of conductive material. In this way, the electromagnetic interference on the shielded cable (A) is grounded. In preferred embodiments of the present invention, metal or alloys are used as conductive material. In a preferred embodiment of the present invention, the lower body (10) is secured to the opening on the mounting panel (70) by at least one connecting element (60). The lower body (10) may also be secured to the mounting panel (70) by other fastening methods which may be performed by a person skilled in the art. At least one housing (11) is provided on the lower body (10) allowing cable passage. The housing (11) is preferably in conical form. The width of the housing (11) also permits the passage of pre-terminated cables in the form of connectors, cable lugs, etc.

At least one sealing element (30) is fixed in the housing (11) on the lower body (10). The sealing element (30) prevents the passage of dust, liquid, etc. behind the mounting panel (70) after the installation of the cable feedthrough element (B). Therefore, the sealing element (30) provides sealing protection. The sealing element (30) is preferably made of elastomeric material. In the preferred embodiment of the present invention, the sealing element (30) has a slit (31). The slit (31) provides ease of installation, especially in pre-terminated cables. In different embodiments of the cable feedthrough element (B), the sealing element (30) may also be fixed to different parts of the structure. In preferred embodiments of the invention, the sealing element (30) is mounted after the contact element (40). Thus, the user can monitor the contact of the shielded cable (A) with the contact element (40). This ensures correct installation and increases customer satisfaction. In addition, loose contact due to wrong assembly can be detected immediately. Therefore, damage to the system and users is prevented. The contact of the shielded cable (A) to the contact element (40) enables the detection of faults and intervention more quickly in systems where there is plurality of cables.

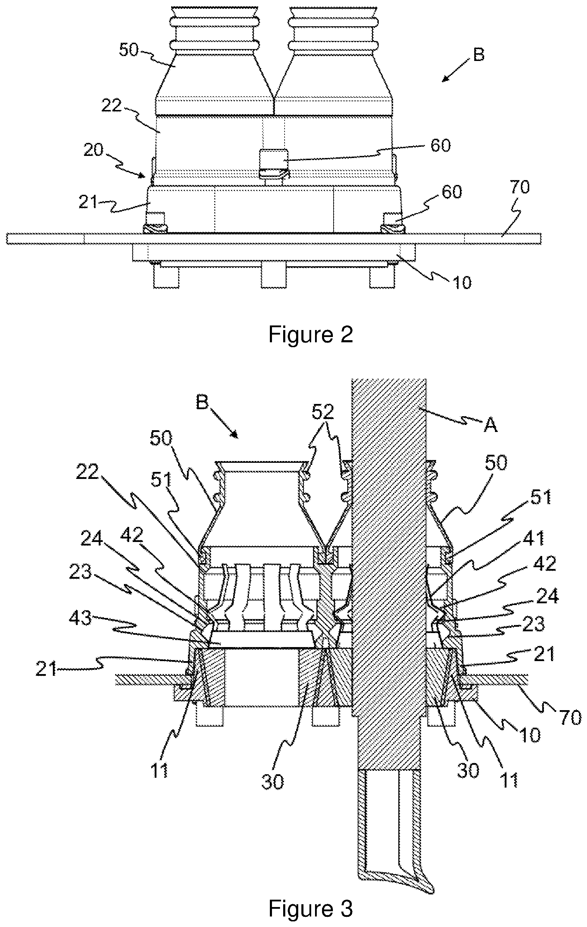

Referring to Fig. 2, the upper body (20) comprises a shelter part (21) surrounding at least one housing (11) and at least one tubular part (22) protruding on the upper body (20). The upper body (20) is preferably made of conductive material. In preferred embodiments of the present invention, metal or alloys are used as conductive. The upper body (20) is preferably mounted on the lower body (10) by means of connecting elements (60). However, in different embodiments of the invention, the upper body (20) can be mounted to the lower body (10) by snap-fit or other mounting methods and elements.

The shelter part (21) surrounds at least one housing (11) located on the lower body (10). Thus, the shelter part (21) builds continuity between the lower body (10) and the upper body (20). The shelter part (21) screens the cables passing through the housings (11) in every direction and ensures the continuity of EMC feature. In addition, the shelter part (21) provides for alignment of the lower body (10) and the upper body (20). This reduces installation faults.

Referring to Fig. 3, the tubular part (22) rises on the upper body (20), allowing the passage of the shielded cable (A). The contact element (40) is mounted in the interior of the tubular part (22). The tubular part (22) and the contact element (40) allow the passage of pre-terminated cables in the form of connectors, cable lugs, etc. In this way, it is not necessary to remove the contact element (40) from the tubular part (22) during cable assembly. This shortens the installation duration. It also prevents the contact element (40) to be lost during assembly. In preferred embodiments of the invention, the tubular part (22) rising on the upper body (20) are designed close to each other in order to save space. Thus, the invention can be used in applications where the cable diameters are relatively large and the installation space is limited.

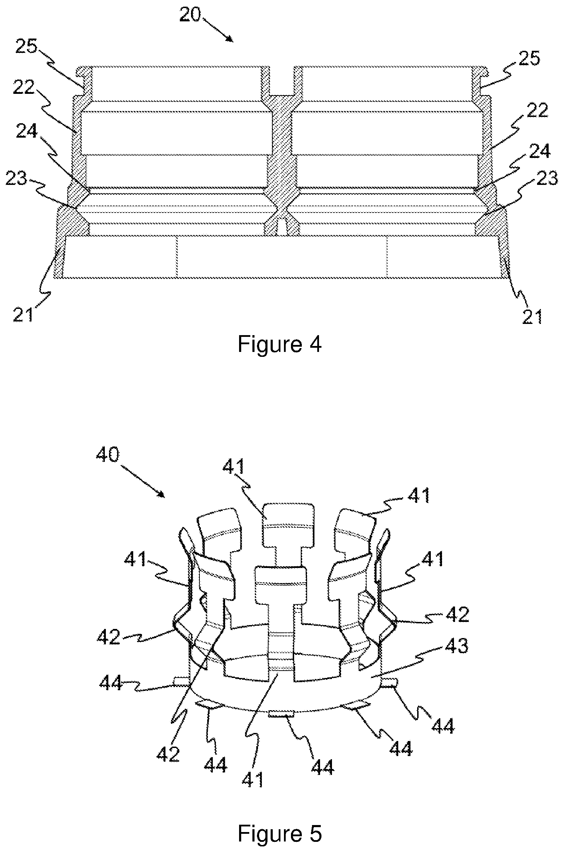

Referring to Fig. 3 and Figure 4 at least one protrusion (24) is provided on the tubular part. Referring to Fig. 4, there is a protrusion (24) adjacent the groove (23) formed in the tubular part (22). The surface of the protrusion (24) facing the groove (23) is inclined. Thus, when the contact element (40) is pushed by the sealing element (30), the bend (42) on the contact spring (41) easily comes out of the groove (23). The other surface of the protrusion (24) has a structure that prevents returning of the bend (42) to the groove (23). In preferred embodiments of the invention, the other surface of the protrusion (24) is perpendicular to the direction in which the bend (42) returns to the groove (23). The protrusion (24) prevents the bend (42) to return back into the groove (23) after the contact element (40) has clamped the shielded cable (A). Thus, the clamping of the shielded cable (A) by the contact element (40) is guaranteed and continuous contact with the shielded cable (A) is ensured. This prevents the reduction of the EMC feature by aging.

Referring to Fig. 5, the contact element (40) comprises at least one contact spring (41) and at least one retaining ring (43). The contact element (40) contacts the shield of the cable to provide grounding. As a result, electromagnetic compatibility (EMC) is ensured in the system. The contact spring (41) contacts the shield of cable at at least one point. At least one bend (42) is provided on the contact spring (41). Said bend (42) engages the groove (23) in the tubular part (22). Thus, it is ensured that the contact element (40) is positioned in the tubular part (22). At least one contact spring (41) is provided on the retaining ring (43). The retaining ring (43) that contacts the sealing element (30) is a portion of the contact element (40). At least one extension (44) is provided on the retaining ring (43). The extension (44) increases the contact surface between the contact element (40) and the sealing element (30). This prevents the sealing element (30) from being damaged by the contact element (40) during assembly of the upper body (20) to the lower body (10).

In a preferred embodiment of the present invention, a shroud (50) is used to provide sealing protection to the cable feedthrough element (B) and to protect the contact element (40) from external effects. The shroud (50) is inserted on the edge of the tubular part (22). The tab (51) formed on the shroud (50) engages the recess (25) formed in the edge of the tubular part (22). In preferred embodiments of the invention, the shroud (50) is made of elastic material. At least one annular extension (52) is provided on the shroud (50). The annular extension (52) has two basic functions. The first is to increase the strength of the shroud (50). The second is to limit the movement of the clamp, clip, or similar clamping member mounted on the shroud (50). This prevents dislocating of the clamping member.

When the upper body (20) is assembled to the lower body (10), the contact element (40) automatically contacts the shield of the cable. During the assembly of the upper body (20), the contact element (40) is pushed by the sealing element (30). Thus, the contact element (40) moves in the opposite direction of the upper body (20) in the tubular part (22) and comes out of the groove (23). As the bends (42) come out of the groove (23), the contact springs (41) converge in and press the shield of the cable. The protrusion (24) adjacent to the groove (23) prevents the contact element (40) from returning and entering the groove (23). This enables the contact element (40) to clamp the shielded cable (A) continuously. Therefore, the clamping force of the contact element (40) on the shielded cable (A) is not reduced over time. By the help of the invention, the EMC property of the cable feedthrough element (B) continues without being affected by aging.

## Claims

1. A cable feedthrough element (B) for installing shielded cables (A), comprising:
- a lower body (10) mountable in the opening on a mounting panel (70) and having at least one housing (11) providing passage of the shielded cable (A),
- at least one sealing element (30) disposed in said at least one housing (11) and providing sealing protection,
- an upper body (20) mountable on the lower body (10),
- at least one tubular part (22) protruding on the upper body (20) and providing passage of shielded cable (A),
- at least one contact element (40) for contacting the shielded cable (A) and having at least one contact spring (41) contacting on at least one point of the shielded cable (A) when the shielded cable (A) is pressed, said contact spring (41) having at least one bend (42), wherein:
- the tubular part (22) comprises a groove (23) and the at least one bend (42) on the contact spring (41) is configured to retain the contact element (40) in the tubular part (22) by engaging this groove (23),
- at least one retaining ring (43) which has the at least one contact spring (41) on it, is configured to provide a contact surface between the contact element (40) and the sealing element (30) wherein the sealing element (30) is configured to push the contact element (40) in such a way that the bend (42) dislocates from the groove (23) during the assembly of the upper body (20) to the lower body (10), and
- at least one protrusion (24) is on the tubular part (22) which allows the contact element (40) to continuously press the shielded cable (A) by preventing the bend (42) to return back to the groove (23).

2. A cable feedthrough element (B) according to claim 1, **characterized in that** said upper body (20) comprises a shelter part (21) adapted to surround the at least one housing (11) and configured to allow the lower body (10) and the upper body (20) to be aligned.

3. A Cable feedthrough element (B) according to claim 1, **characterized in that**; said lower body (10), said upper body (20) and said contact element (40) are made of conductive material.

4. A Cable feedthrough element (B) according to claim 1, **characterized in that**; said at least one housing (11) is in conical form.

5. A Cable feedthrough element (B) according to claim 1, **characterized in that**; said sealing element (30) provides a slit (31) for passage to pre-terminated cables.

6. A cable feedthrough element (B) according to claim 1, **characterized in** comprising a shroud (50) positioned at the end of the tubular part (22), which provides sealing protection to the cable feedthrough element (B) and protects the contact element (40) from external effects.

7. A cable feedthrough element (B) according to claim 6, **characterized in** comprising at least one tab (51) on said shroud (50) which connects said shroud (50) to at least one recess (25) formed at the end of said tubular part (22).

8. A cable feedthrough element (B) according to claim 6, **characterized in** comprising at least one annular extension (52) on said shroud (50), which increases the strength of said shroud (50) and prevents the movement of a clamping element disposed on said shroud (50).

9. A cable feedthrough element (B) according to claim 1, **characterized in** comprising at least one connecting element (60) for assembling said upper body (20) to said lower body (10).

10. A cable feedthrough element (B) according to claim 1, **characterized in** comprising an extension (44) on said retaining ring (43) which increases the contact surface between said contact element (40) and said sealing element (30).

## Patentansprüche

1. Kabeldurchführungselement (B) zum Installieren abgeschirmter Kabel (A), das folgende Merkmale aufweist:
- einen unteren Körper (10), der in der Öffnung an einer Montageplatte (70) montierbar ist und zumindest ein Gehäuse (11) aufweist, das einen Durchgang des abgeschirmten Kabels (A) bereitstellt,
- zumindest ein Dichtungselement (30), das in dem zumindest einen Gehäuse (11) angeordnet ist und einen Dichtungsschutz bereitstellt,
- einen oberen Körper (20), der an dem unteren Körper (10) montierbar ist,
- zumindest einen rohrförmigen Teil (22), der an dem oberen Körper (20) vorsteht und einen Durchgang des abgeschirmten Kabels (A) bereitstellt,
- zumindest ein Kontaktelement (40) zum Kontaktieren des abgeschirmten Kabels (A), das zumindest eine Kontaktfeder (41) aufweist, die an zumindest einem Punkt des abgeschirmten Kabels (A) kontaktiert, wenn das abgeschirmte Kabel (A) gedrückt wird, wobei die Kontaktfeder (41) zumindest eine Biegung (42) aufweist, wobei:
- der rohrförmige Teil (22) eine Rille (23) aufweist und die zumindest eine Biegung (42) an der Kontaktfeder (41) dazu konfiguriert ist, das Kontaktelement (40) durch Eingreifen in diese Rille (23) in dem rohrförmigen Teil (22) zu halten,
- zumindest ein Haltering (43), der die zumindest eine Kontaktfeder (41) daran aufweist, dazu konfiguriert ist, eine Kontaktoberfläche zwischen dem Kontaktelement (40) und dem Dichtungselement (30) bereitzustellen, wobei das Dichtungselement (30) dazu konfiguriert ist, das Kontaktelement (40) derart zu drücken, dass sich die Biegung (42) während des Zusammenbaus des oberen Körpers (20) an den unteren Körper (10) von der Rille (23) verlagert, und
- sich zumindest ein Vorsprung (24) an dem rohrförmigen Teil (22) befindet, der es dem Kontaktelement (40) ermöglicht, das abgeschirmte Kabel (A) kontinuierlich zu drücken, indem verhindert wird, dass die Biegung (42) zu der Rille (23) zurückkehrt.

2. Kabeldurchführungselement (B) gemäß Anspruch 1, **dadurch gekennzeichnet, dass** der obere Körper (20) einen Schutzteil (21) aufweist, der dazu angepasst ist, das zumindest eine Gehäuse (11) zu umgeben, und dazu konfiguriert ist, eine Ausrichtung des unteren Körpers (10) und des oberen Körpers (20) zu ermöglichen.

3. Kabeldurchführungselement (B) gemäß Anspruch 1, **dadurch gekennzeichnet, dass** der untere Körper (10), der obere Körper (20) und das Kontaktelement (40) aus leitfähigem Material hergestellt sind.

4. Kabeldurchführungselement (B) gemäß Anspruch 1, **dadurch gekennzeichnet, dass** das zumindest eine Gehäuse (11) eine konische Form aufweist.

5. Kabeldurchführungselement (B) gemäß Anspruch 1, **dadurch gekennzeichnet, dass** das Dichtungselement (30) einen Schlitz (31) für den Durchgang zu vorgefertigten Kabeln bereitstellt.

6. Kabeldurchführungselement (B) gemäß Anspruch 1, **dadurch gekennzeichnet, dass** es eine Ummantelung (50) aufweist, die an dem Ende des röhrenförmigen Teils (22) positioniert ist, die einen Dichtungsschutz für das Kabeldurchführungselement (B) bereitstellt und das Kontaktelement (40) vor äußeren Einwirkungen schützt.

7. Kabeldurchführungselement (B) gemäß Anspruch 6, **dadurch gekennzeichnet, dass** es zumindest eine Lasche (51) an der Ummantelung (50) aufweist, die die Ummantelung (50) mit zumindest einer Aussparung (25) verbindet, die an dem Ende des röhrenförmigen Teils (22) gebildet ist.

8. Kabeldurchführungselement (B) gemäß Anspruch 6, **dadurch gekennzeichnet, dass** es zumindest eine ringförmige Erweiterung (52) an der Ummantelung (50) aufweist, die die Festigkeit der Ummantelung (50) erhöht und die Bewegung eines Klemmelements verhindert, das an der Ummantelung (50) angeordnet ist.

9. Kabeldurchführungselement (B) gemäß Anspruch 1, **dadurch gekennzeichnet, dass** es zumindest ein Verbindungselement (60) zum Zusammenbauen des oberen Körpers (20) an den unteren Körper (10) aufweist.

10. Kabeldurchführungselement (B) gemäß Anspruch 1, **dadurch gekennzeichnet, dass** es eine Erweiterung (44) an dem Haltering (43) aufweist, die die Kontaktoberfläche zwischen dem Kontaktelement (40) und dem Dichtungselement (30) vergrößert.

## Revendications

1. Élément de passage de câble (B) pour installer des câbles blindés (A), comprenant :
- un corps inférieur (10) montable dans l'ouverture sur un panneau de montage (70) et présentant au moins un logement (11) assurant le passage du câble blindé (A),
- au moins un élément d'étanchéité (30) disposé dans ledit au moins un logement (11) et offrant une protection étanche,
- un corps supérieur (20) montable sur le corps inférieur (10),
- au moins une partie tubulaire (22) faisant saillie sur le corps supérieur (20) et assurant le passage de câble blindé (A),
- au moins un élément de contact (40) pour établir un contact avec le câble blindé (A) et présentant au moins un ressort de contact (41) en contact avec au moins un point du câble blindé (A) lorsque le câble blindé (A) est plaqué, ledit ressort de contact (41) présentant au moins une courbure (42), dans lequel :
- la partie tubulaire (22) comprend une rainure (23) et l'au moins une courbure (42) sur le ressort de contact (41) est configurée pour retenir l'élément de contact (40) dans la partie tubulaire (22) par mise en prise avec cette rainure (23),
- au moins une bague de retenue (43) sur laquelle est présent l'au moins un ressort de contact (41), est configurée pour fournir une surface de contact entre l'élément de contact (40) et l'élément d'étanchéité (30), dans lequel l'élément d'étanchéité (30) est configuré pour pousser l'élément de contact (40) de sorte que la courbure (42) quitte la rainure (23) pendant l'assemblage du corps supérieur (20) au corps inférieur (10), et
- au moins une saillie (24) est présente sur la partie tubulaire (22), laquelle permet à l'élément de contact (40) d'exercer une pression continue sur le câble blindé (A) en empêchant la courbure (42) de revenir dans la rainure (23).

2. Élément de passage de câble (B) selon la revendication 1, **caractérisé en ce que** ledit corps supérieur (20) comprend une partie protectrice (21) conçue pour entourer l'au moins un logement (11) et configurée pour permettre l'alignement du corps inférieur (10) et du corps supérieur (20).

3. Élément de passage de câble (B) selon la revendication 1, **caractérisé en ce que** ; ledit corps inférieur (10), ledit corps supérieur (20) et ledit élément de contact (40) sont en matériau conducteur.

4. Élément de passage de câble (B) selon la revendication 1, **caractérisé en ce que** ; ledit au moins un logement (11) est de forme conique.

5. Élément de passage de câble (B) selon la revendication 1, **caractérisé en ce que** ; ledit élément d'étanchéité (30) fournit une fente (31) destinée au passage de câbles pré-connectorisés.

6. Élément de passage de câble (B) selon la revendication 1, **caractérisé en ce qu'**il comprend une coiffe (50) positionnée à l'extrémité de la partie tubulaire (22), qui assure une protection étanche à l'élément de passage de câble (B) et protège l'élément de contact (40) des effets extérieurs.

7. Élément de passage de câble (B) selon la revendication 6, **caractérisé en ce qu'**il comprend au moins une patte (51) sur ladite coiffe (50) qui relie ladite coiffe (50) à au moins un évidement (25) formé à l'extrémité de ladite partie tubulaire (22).

8. Élément de passage de câble (B) selon la revendication 6, **caractérisé en ce qu'**il comprend au moins une extension annulaire (52) sur ladite coiffe (50), qui accroît la résistance de ladite coiffe (50) et empêche le mouvement d'un élément de serrage disposé sur ladite coiffe (50).

9. Élément de passage de câble (B) selon la revendication 1, **caractérisé en ce qu'**il comprend au moins un élément de liaison (60) pour assembler ledit corps supérieur (20) audit corps inférieur (10).

10. Élément de passage de câble (B) selon la revendication 1, **caractérisé en ce qu'**il comprend une extension (44) sur ladite bague de retenue (43) qui augmente la surface de contact entre ledit élément de contact (40) et ledit élément d'étanchéité (30).
